Europäisches Patentamt

European Patent Office

Office européen des brevets

(19)

(11) Veröffentlichungsnummer : **0 334 447 B1**

(12) **EUROPÄISCHE PATENTSCHRIFT**

(45) Veröffentlichungstag der Patentschrift :
**14.09.94 Patentblatt 94/37**

(21) Anmeldenummer : **89200696.6**

(22) Anmeldetag : **20.03.89**

(51) Int. Cl.⁵ : **H03K 3/295**

(54) Schmitt-Trigger-Schaltung.

(30) Priorität : **25.03.88 DE 3810058**

(43) Veröffentlichungstag der Anmeldung :
**27.09.89 Patentblatt 89/39**

(45) Bekanntmachung des Hinweises auf die
Patenterteilung :
**14.09.94 Patentblatt 94/37**

(84) Benannte Vertragsstaaten :
**DE FR GB IT NL**

(56) Entgegenhaltungen :
**US-A- 4 463 271**
**US-A- 4 556 805**
**PATENT ABSTRACTS OF JAPAN, Band 1, Nr.
104, 14. September 1977, Seite 3486 E77 ; &
JP-A-52 37 759 (SONY K.K.) 23-03-1977**
**PATENT ABSTRACTS OF JAPAN, Band 9, Nr.
298 (E-361)[2021], 26. November 1985 ; &
JP-A-60 136 413 (TOSHIBA K.K.) 19-07-1985**
**PATENT ABSTRACTS OF JAPAN, Band 8, Nr.
111 (E-246)[1548], 24. Mai 1984 ; & JP-A-59 27
616 (SANYO DENKI K.K.) 14-02-1984**

(73) Patentinhaber : **Philips Patentverwaltung
GmbH
Wendenstrasse 35c
D-20097 Hamburg (DE)**
㊱ **DE**
Patentinhaber : **N.V. Philips'
Gloeilampenfabrieken
Groenewoudseweg 1
NL-5621 BA Eindhoven (NL)**
㊱ **FR GB IT NL**

(72) Erfinder : **Martiny, Ingo
Wildacker 52
D-2000 Hamburg 54 (DE)**

(74) Vertreter : **Kupfermann, Fritz-Joachim,
Dipl.-Ing.
Philips Patentverwaltung GmbH
Wendenstrasse 35
Postfach 10 51 49
D-20035 Hamburg (DE)**

Anmerkung : Innerhalb von neun Monaten nach der Bekanntmachung des Hinweises auf die Erteilung
des europäischen Patents kann jedermann beim Europäischen Patentamt gegen das erteilte europäische Patent Einspruch einlegen. Der Einspruch ist schriftlich einzureichen und zu begründen. Er gilt
erst als eingelegt, wenn die Einspruchsgebühr entrichtet worden ist (Art. 99(1) Europäisches Patentübereinkommen).

Jouve, 18, rue Saint-Denis, 75001 PARIS

**Beschreibung**

Die Erfindung bezieht sich auf eine Schmitt-Trigger-Schaltung nach dem Oberbegriff des Patentanspruchs 1.

Aus der JP-A-60-136413 (A) ist eine Schmitt-Trigger-Schaltung bekannt, die zwei emittergekoppelte Transistoren enthält. Der Basis eines Transistors (erster Eingang) wird die Eingangsspannung zugeführt. Der zweite Eingang, die Basis des zweiten Transistors, ist mit einem Stromspiegel und mit dem Kollektor des zweiten Transistors verbunden. Die Emitter des ersten und zweiten Transistors sind mit einer Stromquelle verbunden.

Die bekannte Schmitt-Trigger-Schaltung läßt sich in integrierter Schaltungstechnik schwer herstellen, da Widerstände, insbesondere mit hohen Werten, schlecht integrierbar sind.

Der Erfindung liegt daher die Aufgabe zugrunde, eine Schmitt-Trigger-Schaltung zu schaffen, die keine Widerstände verwendet.

Diese Aufgabe wird bei einer Schmitt-Trigger-Schaltung der eingangs genannten Art durch die im Patentanspruch 1 gekennzeichneten Merkmale gelöst.

Bei dieser Schmitt-Trigger-Schaltung fließt, wenn das Eingangssignal genügend klein ist, ein Strom über die Eingangsstufe des ersten Stromspiegels und den Differenzverstärker in die erste Stromquelle. Der vom ersten Stromspiegel gespiegelte Strom fließt aus dessen Ausgangsstufe über die Halbleiterstrecke in die zweite Stromquelle. In der ersten Diodenstrecke fließt kein Strom, da die Spannung über dem ersten Stromspiegelausgang und der Halbleiterstrecke kleiner ist als zwei Diodenspannungen. Bei einem ausreichend großen Eingangssignal ist der erste Stromspiegel und die Halbleiterstrecke stromlos. Der Strom, der in die zweite Stromquelle fließt, wird von der ersten Diodenstrecke geliefert.

Wenn die Halbleiterstrecke eine Basis-Emitterstrecke eines Rückkopplungstransistors ist, dessen Basis mit dem Ausgang des ersten Stromspiegels verbunden und dessen Emitter mit der Basis des zweiten Transistors gekoppelt ist, bekommt man eine größere Stromverstärkung vom Ausgang des ersten Stromspiegels zur Basis des zweiten Transistors und daher eine schnellere Umschaltung der Trigger-Schaltung.

Das Ausgangssignal kann beispielsweise über einen weiteren Stromspiegel an der ersten Diodenstrecke gewonnen werden. Der Wechsel des Ausgangssignals von einem niedrigen auf einen hohen Pegel findet bei einer ersten Schaltschwelle statt, die von der Spannung der Ausgangsstufe des ersten Stromspiegels und der Basis-Emitter-Spannung des Rückkopplungstransistors abhängt. Die zweite Schaltschwelle, bei welcher der Wechsel von einem hohen auf einen niedrigen Pegel stattfindet, hängt von der Summe der Durchlaßspannungen der Diodenelemente in der ersten Diodenstrecke ab.

Die erste Diodenstrecke muß aus wenigstens zwei in Reihe geschalteten Diodenelementen bestehen. Die Diodenelemente sind für den Strom, der zur zweiten Stromquelle fließt, in Durchlaßrichtung geschaltet.

Die Breite der Hysterese, d.h. der Abstand zwischen den beiden Schaltschwellen, wird durch die Anzahl der Diodenelemente der ersten Diodenstrecke bestimmt. Die Schaltschwellen können auch bei gleichem Abstand verkleinert werden, indem zwischen den ersten und den zweiten Kopplungspunkt eine zweite Diodenstrecke geschaltet ist.

Vorzugsweise wird das Ausgangssignal mittels eines Stromspiegels an der ersten Diodenstrecke ausgekoppelt. Dabei ist vorgesehen, daß die erste Diodenstrecke strommäßig in einer Eingangsstufe eines zweiten Stromspiegels aufgenommen ist, der mit einer Ausgangsstufe an der Ausgangsklemme angeschlossen ist.

An der Ausgangsstufe des ersten Stromspiegels kann in dem stromlosen Schaltzustand ein Leckstrom auftreten, der durch Temperaturänderungen oder Kristalldefekte hervorgerufen wird. Um diesen Leckstrom abzuführen (abzusaugen) ist vorgesehen, daß der Kollektor des ersten Transistors verbunden ist mit einem Eingang eines dritten Stromspiegels, von dem ein Ausgang gekoppelt ist mit einem Eingang eines vierten Stromspiegels, von dem ein Ausgang an die Basis des Rückkopplungstransistors geschaltet ist. Hierbei wird der Leckstrom durch die Ausgangsstufe des vierten Stromspiegels abgeführt. Außerdem wird die Kreisverstärkung erhöht und damit die Flankensteilheit des Ausgangssignals an der oberen Schaltschwelle erhöht.

Um zu verhindern, daß bei hoher Eingangsspannung der erste Transistor des Differenzverstärkers in die Sättigung geht, ist vorgesehen, daß die Eingangsklemme über eine Eingangsdiodenstrecke mit der Basis des ersten Transistors gekoppelt ist.

In einer anderen Weiterbildung der Erfindung ist vorgesehen, daß vor den Eingang des ersten Stromspiegels eine Eingangsstufe eines fünften Stromspiegels geschaltet ist, von dem eine Ausgangsstufe mit einer Eingangsstufe eines sechsten Stromspiegels gekoppelt ist, der mit einer Ausgangsstufe an der Ausgangsklemme angeschlossen ist. Diese Weiterbildung kann dazu dienen, den Leckstrom der Ausgangsstufe des zweiten Stromspiegels im stromlosen Schaltzustand abzuführen. Hierbei sind dann die Ausgangsstufen des zweiten und sechsten Stromspiegels miteinander verbunden.

Die Weiterbildung kann auch dazu dienen, das Ausgangssignal einer in $I^2L$-Technik ausgebildeten Schaltung zuzuführen. In diesem Fall ist der zweite Stromspiegel nicht erforderlich und die erste und die zweite Stromquelle bilden jeweils eine Strombank mit Transistoren, deren Basen mit einem gemeinsamen Injektor verbunden sind.

Ausführungsbeispiele der Erfindung werden nachstehend anhand der Zeichnungen näher erläutert. Es zeigen:

Fig. 1 eine vereinfacht dargestellte Schmitt-Trigger-Schaltung,

Fig. 2 die Übertragungskennlinie der Schmitt-Trigger-Schaltung und

Fig. 3 und 4 etwas detailliertere Ausführungsbeispiele der Schmitt-Trigger-Schaltung.

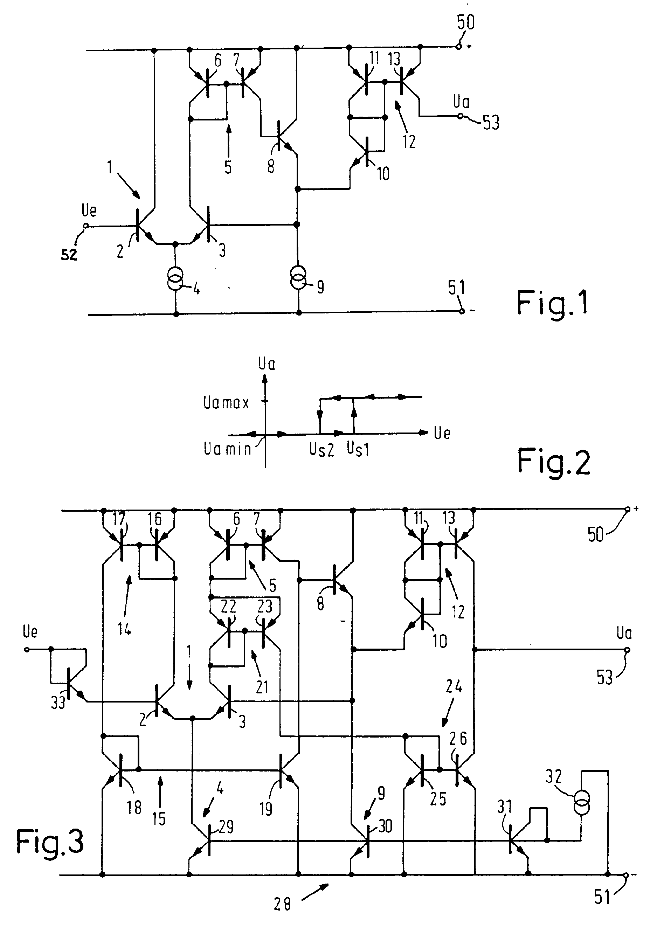

Die in Fig. 1 vereinfacht dargestellte Schmitt-Trigger-Schaltung enthält einen Differenzverstärker 1 mit zwei NPN-Transistoren 2 und 3, deren Emitter an eine Stromquelle 4 angeschlossen sind. Der andere Anschluß der Stromquelle 4 ist an den negativen Versorgungsspannungsanschluß einer Spannungsquelle angeschlossen. Der Kollektor des Transistors 2 ist an den positiven Versorgungsspannungsanschluß 50 der Spannungsquelle angeschlossen, und der Basis des Transistors 2 wird eine Eingangsspannung Ue an Eingangsanschluß 52 geliefert. Der Kollektor des Transistors 3 ist mit einer Eingangsstufe eines ersten Stromspiegels 5 verbunden. Die Eingangsstufe enthält einen PNP-Transistor 6, dessen Emitter an den positiven Versorgungsspannungsanschluß 50 und dessen Basis und Kollektor an den Kollektor des Transistors 3 angeschlossen sind. Die Ausgangsstufe des Stromspiegels 5 bildet ein PNP-Transistor 7, dessen Basis mit der Basis des Transistors 6 verbunden ist und dessen Emitter ebenfalls an den positiven Versorgungsspannungsanschluß 50 geschaltet ist. Der Kollektor des Transistors 6 ist mit der Basis eines Rückkopplungstransistors 8 vom NPN-Typ verbunden, dessen Kollektor an den positiven Versorgungsspannungsanschluß 50 gelegt ist und dessen Emitter mit einer zweiten Stromquelle 9, der Basis des Transistors 3 und dem Emitter eines als Diodenelement geschalteten NPN-Transistors 10 verbunden ist. Der andere Anschluß der Stromquelle 9 ist an den negativen Versorgungsspannungsanschluß 51 geschaltet. Die Basis und der Kollektor des Transistors 10 sind an den Kollektor und die Basis eines PNP-Transistors 11 angeschlossen, der die Eingangsstufe eines zweiten Stromspiegels 12 bildet. Der Emitter des Transistors 11 ist ebenso wie der Emitter eines PNP-Transistors 13 an den positiven Versorgungsspannungsanschluß 50 gelegt. Die Basis des Transistors 13 ist mit der Basis des Transistors 11 verbunden. Der Kollektor des Transistors 13 bildet den Ausgang 53 der Schmitt-Trigger-Schaltung.

Mit Hilfe der Übertragungskennlinie in Fig. 2 wird die Funktionsweise der Schmitt-Trigger-Schaltung im folgenden erläutert. Ist das Eingangssignal Ue negativ, ist der Transistor 2 gesperrt und der Transistor 3 leitend. Über den Transistor 6 des Stromspiegels 5 und die Kollektor-Emitter-Strecke des Transistors 3 fließt ein Strom in die Stromquelle 4. Der Stromquelle 9 wird ein ungefähr gleichgroßer Strom vom leitenden Rückkopplungstransistor 8 geliefert. Der Transistor 7 in der Ausgangsstufe des Stromspiegels 5 ist in der Sättigung. Da der Transistor 8 leitend ist, ist die Diodenstrecke der beiden als Diodenelemente geschalteten Transistoren 10 und 11 kurzgeschlossen. Der Stromspiegel 12 ist daher stromlos und am Ausgang wird eine Ausgangsspannung Uamin von ungefähr Null geliefert, bezogen auf den negativen Versorgungsspannungsanschluß 51.

Ein Wechsel der Ausgangsspannung Ua von einem niedrigen Pegel Uamin auf einen hohen Pegel Uamax ergibt sich bei einer Eingangsspannung Ue, die gleich Us1 ist. In diesem Fall wird der Transistor 3 gesperrt und der Transistor 2 leitend. Über den Stromspiegel 5 fließt kein Strom mehr und der Transistor 8 ist gesperrt. Die Stromquelle 9 zieht sich ihren Strom aus dem Stromspiegel 12 und dem Transistor 10. Die Ausgangsspannung ist in diesem Fall gleich dem Produkt aus dem Strom der Stromquelle 9 und einem hier nicht eingezeichneten Lastwiderstand. Die Ausgangsspannung Ua wechselt von einem hohen Pegel Uamax zu einem niedrigen Pegel Uamin bei einer Schaltschwelle Us2. Die Schaltschwelle Us1 ist größer als die Schaltschwelle Us2. Bestimmt wird die Schaltschwelle Us1 von der Sättigungsspannung des Transistors 7 und der Basis-Emitter-Spannung des Transistors 8. Für die Schaltschwelle Us1 gilt folgende Gleichung:

$$Us1 = Up - Usat7 - Ube8,$$

wobei Up die Versorgungsspannung an dem Versorgungsspannungsanschluß 50 ist, Usat7 die Sättigungsspannung des Transistors 7 und Ube8 die Basis-Emitter-Spannung des Transistors 8 ist.

Die Schaltschwelle Us2 wird durch die Basis-Emitter-Spannungen der Transistoren 10 und 11 definiert. Für die Schaltschwelle Us2 gilt folgende Gleichung:

$$Us2 = Up - Ube10 - Ube11.$$

wobei Ube10 die Basis-Emitter-Spannung des Transistors 10 und Ube11 die Basis-Emitter-Spannung des Transistors 11 ist.

Der Abstand der beiden Schaltschwellen Us1 und Us2 kann durch weitere als Diodenelemente geschaltete Transistoren vergrößert werden. Diese als Diodenelemente geschalteten Transistoren müssen zum Transistor 10 in Reihe geschaltet werden. Ebenso kann die Lage der Schalthysterese durch weitere als Diodenelemente geschaltete Transistoren verändert werden. Der Abstand der beiden Schaltschwellen bleibt in diesem Fall gleich. Die als Diodenelemente geschalteten Transistoren müssen zwischem den Verbindungspunkt der Emitter der Transistoren 8 und 10 und den Verbindungspunkt der Basis des Transistors 3 mit der Stromquelle 9 angeordnet werden.

Im gesperrten Zustand des Transistors 3, wenn der Stromspiegel 5 stromlos sein soll, können durch Kristalldefekte oder Temperaturveränderungen Leckströme vom Transistor 7 geliefert werden. Auch die Ausgangsstufe des zweiten Stromspiegels 12 kann einen Leckstrom liefern. Das in Fig. 3 dargestellte Ausführungsbeispiel ist gegenüber dem Ausführungsbeispiel der Fig. 1 um einige Stromspiegel erweitert worden, die bewirken, daß die Leckströme abgesaugt werden. Der Kollektor des Transistors 2 ist mit einer Eingangsstufe eines dritten Stromspiegels 14 verbunden, dessen Ausgangsstufe mit einem vierten Stromspiegel 15 gekoppelt ist. Die Eingangsstufe des Stromspiegels 14 enthält einen PNP-Transistor 16, dessen Emitter an den positiven Versorgungsspannungsanschluß und dessen Basis und Kollektor an den Kollektor des Transistors 2 angeschlossen sind. Der die Ausgangsstufe des Stromspiegels 14 bildende PNP-Transistors 17 ist ebenfalls mit seinem Emitter an dem positiven Versorgungsspannungsanschluß angeschlossen und dessen Basis an die Basis des Transistors 16. Der Kollektor des Transistors 17 bildet den Ausgang des Stromspiegels 14. Dieser ist mit der Basis und dem Kollektor eines die Eingangsstufe des Stromspiegels 15 bildenden NPN-Transistors 18 verbunden. Der Emitter des Transistors 18 ist an den negativen Versorgungsspannungsanschluß geschaltet. Die Ausgangsstufe des Stromspiegels 15 wird durch einen NPN-Transistor 19 gebildet, dessen Kollektor mit der Basis des Rückkopplungstransistors 8 und dem Kollektor des Transistors 7 gekoppelt ist. Der Emitter ist an den negativen Versorgungsspannungsanschluß gelegt und die Basis des Transistors 19 ist an die Basis des Transistors 18 angeschlossen. Ein Leckstrom, der vom Kollektor des Transistors 7 geliefert wird, wird von dem Transistor 19 abgesaugt. Zusätzlich bewirkt der dritte und vierte Stromspiegel, daß die Kreisverstärkung erhöht und damit die Flankensteilheit des Ausgangssignals an der Schaltschwelle Us1 erhöht wird.

Zwischem dem Kollektor des Transistors 3 und der Eingangsstufe des ersten Stromspiegels 5 ist ein fünfter Stromspiegel 21 geschaltet, der aus den PNP-Transistoren 22 und 23 besteht. Die Basis des Transistors 22 und die Basis des Transistors 23 sind mit dem Kollektor des Transistors 3 und dem Kollektor des Transistors 22 verbunden. Die Emitter der beiden Transistoren sind an die Basis des Transistors 6 angeschlossen. Der Kollektor des Transistors 23 steht mit der Eingangsstufe eines sechsten Stromspiegels 24 in Verbindung. Die Eingangsstufe enthält einen NPN-Transistor 25, dessen Emitter an den negativen Versorgungsspannungsanschluß, dessen Basis und Kollektor an den Kollektor des Transistors 23 angeschlossen sind. Die Ausgangsstufe des sechsten Stromspiegels 24 bildet ein NPN-Transistor 26, dessen Kollektor mit dem Kollektor des Transistors 13 den Ausgang bildet. Der Emitter ist ebenfalls an den negativen Versorgungsspannungsanschluß angeschlossen und dessen Basis an die Basis des Transistors 25 gelegt. Der Transistor 26 saugt den Leckstrom ab, der von dem Kollektor des Transistors 13 geliefert wird, wenn dieser stromlos sein soll.

Die Stromquellen 4 und 9 werden durch die Ausgangsstufen einer Strombank 28 gebildet. Die beiden Ausgangsstufen werden durch jeweils einen NPN-Transistor 29 und 30 gebildet, deren Emitter an den negativen Versorgungsspannungsanschluß angeschlossen sind und deren jeweilige Basis mit der Basis eines NPN-Transistors 31 verbunden ist. Der Kollektor des Transistors 29 ist mit den beiden Emittern der Transistoren 2 und 3 und der Kollektor des Transistors 30 mit der Basis des Transistors 3 verbunden. Der Emitter des Transistors 31 ist auch an den negativen Versorgungsspannungsanschluß angeschlossen und der Kollektor des Transistors 31 mit seiner Basis und einer weiteren Stromquelle 32 verbunden. Der andere Anschluß der Stromquelle ist an den negativen Versorgungsspannungsanschluß gelegt.

Um zu vermeiden, daß bei hohen Eingangsspannungen der Transistor 2 des Differenzverstärkers 1 in die Sättigung gelangt, ist ein als Diodenelement geschalteter Transistor 33 mit der Basis des Transistors 2 verbunden. Das Eingangssignal Ue wird der Basis und dem Kollektor des Transistors 33 zugeführt, dessen Emitter mit der Basis des Transistors 2 verbunden ist. Dadurch verschieben sich die beiden Schaltschwellen $U_s1$ und $U_s2$ um jeweils eine Basis-Emitter-Spannung.

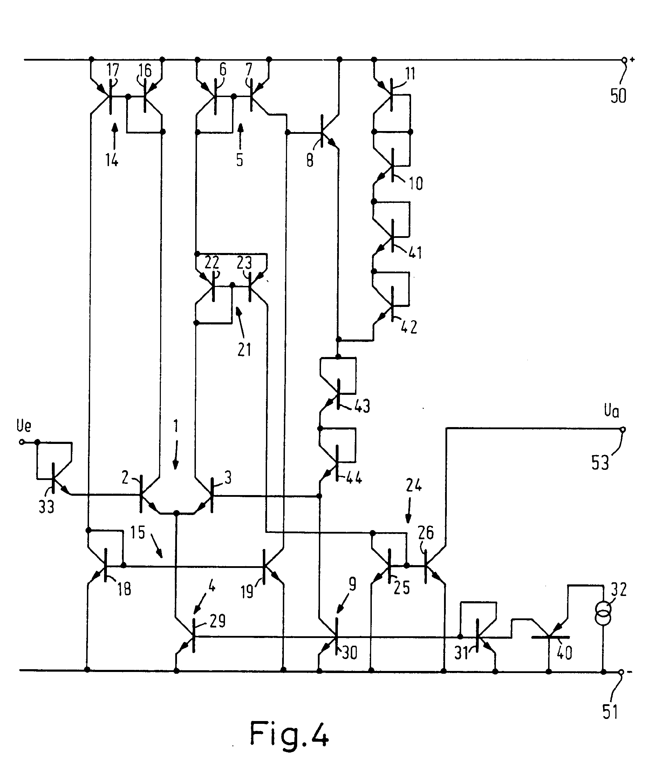

Die Schmitt-Trigger-Schaltung läßt sich auch in einer I²L-Schaltung einsetzen. Ein Ausführungsbeispiel für eine solche Anwendung ist in Fig. 4 dargestellt. Dieses Ausführungsbeispiel unterscheidet sich von dem Ausführungsbeispiel der Fig. 3 dadurch, daß der Transistor 13 wegfällt und die Strombank einen Basisstrom von einem Injektor geliefert bekommt, der durch einen in Basisschaltung arbeitenden PNP-Transistor 40 erzeugt wird. An die Basis des Transistors 31 ist der Kollektor des Transistors 40 gelegt, und der Emitter des Transistors 40 ist an die Stromquelle 32 angeschlossen. Die Basis des Transistors 40 ist an Masse geschaltet. Den Ausgang der Schaltungsanordnung bildet der Kollektor des Transistors 26.

In dem Ausführungsbeispiel sind auch die Schaltschwellen Us1 und Us2 verändert worden, indem weitere als Diodenelemente geschaltete Transistoren einerseits zwischen den Emitteranschluß des Transistors 8 und den Basisanschluß des Transistors 3 und andererseits zwischen den Emitteranschluß des Transistors 8 und den Emitteranschluß des Transistors 10 gelegt worden sind. Ein NPN-Transistor 41 ist mit seinem Kollektor und seiner Basis an den Emitter des Transistors 10 und dessen Emitter an die Basis und den Kollektor eines weiteren NPN-Transistors 42 angeschlossen. Der Emitter des Transistors 42 ist mit dem Emitter des Transistors 8 und mit der Basis und dem Kollektor eines weiteren NPN-Transistors 43 verbunden. Der Emitter des Transistors 43 ist an die Basis und den Kollektor eines NPN-Transistors 44 gelegt, dessen Emitter mit der Basis des Transistors 3 und dem Kollektor des Transistors 30 verbunden ist. Für die Schaltschwelle Us1 gilt folgende Gleichung:

$$Us1 = Up - Usat7 - Ube8 - Ube43 - Ube44 + Ube33,$$

und für die Schaltschwelle Us2 gilt die Gleichung:

$$Us2 = Up - Ube11 - Ube10 - Ube41 - Ube42 - Ube43 - Ube44 + Ube33,$$

wobei Ube33, Ube41, Ube42, Ube43 und Ube44 die Basis-Emitter-Spannungen der Transistoren 33, 41, 42, 43 und 44 sind.

## Patentansprüche

1. Schmitt-Trigger-Schaltung zur Umsetzung eines Eingangssignals (Ue) an einer Eingangsklemme (52) in ein Ausgangssignal (Ua) an einer Ausgangsklemme (53), wobei die Schaltung einen Differenzverstärker (1) enthält mit einem ersten und einem zweiten Transistor (2, 3) mit jeweils einer Basis, einem Emitter und einem Kollektor, wobei der Emitter des ersten und des zweiten Transistors (2,3 ) mit einer ersten Stromquelle (4), die Basis des ersten Transistors (2) mit der Eingangsklemme und der Kollektor des zweiten Transistors (3) mit einem Eingang eines ersten Stromspiegels (5) und die Basis des zweiten Transistors (3) mit einem Ausgang des ersten stromspiegels (5) gekoppelt sind, dadurch gekennzeichnet, daß die Basis des zweiten Transistors (3) mit einer zweiten Stromquelle (9) und über eine Halbleiterstrecke mit dem Ausgang des ersten Stromspiegels (5) sowie mit einer parallel zum ersten Stromspiegel (5) und zur Halbleiterstrecke angeordneten ersten Diodenstrecke aus wenigstens zwei in Reihe, für den zur zweiten Stromquelle fließenden Strom in Durchlaßrichtung geschalteten Diodenelementen (10, 11) gekoppelt ist.

2. Schaltung nach Anspruch 1, dadurch gekennzeichnet, daß die Halbleiterstrecke eine Basis-Emitterstrecke eines Rückkopplungstransistors (8) ist, dessen Basis mit dem Ausgang des ersten Stromspiegels (5) verbunden und dessen Emitter mit der Basis des zweiten Transistors gekoppelt ist.

3. Schaltung nach Anspruch 1 oder 2, dadurch gekennzeichnet, daß zwischen einem ersten Kopplungspunkt der Basis des zweiten Transistors (3) mit der zweiten Stromquelle (9) und einem zweiten Kopplungspunkt der Halbleiterstrecke mit der ersten Diodenstrecke (10, 11) eine zweite Diodenstrecke (43, 44) geschaltet ist.

4. Schaltung nach Anspruch 1, 2 oder 3, dadurch gekennzeichnet, daß die erste Diodenstrecke strommäßig in einer Eingangsstufe eines zweiten Stromspiegels (12) aufgenommen ist, der mit einer Ausgangsstufe (13) an der Ausgangsklemme (53) angeschlossen ist.

5. Schaltung nach Anspruch 2, 3 oder 4, dadurch gekennzeichnet, daß der Kollektor des ersten Transistors (2) verbunden ist mit einem Eingang eines dritten Stromspiegels (14) von dem ein Ausgang mit einem Eingang eines vierten Stromspiegels (15) gekoppelt ist, von dem ein Ausgang an die Basis des Rückkopplungstransistors (8) geschaltet ist.

6. Schaltung nach Anspruch 5, dadurch gekennzeichnet, daß die Eingangsklemme (52) über eine Eingangsdiodenstrecke (33) mit der Basis des ersten Transistors (2) gekoppelt ist.

7. Schaltung nach Anspruch 1, 2, 3, 5 oder 6, dadurch gekennzeichnet, daß vor den Eingang des ersten Stromspiegels (5) eine Eingangsstufe (22) eines fünften Stromspiegels (21) geschaltet ist, von dem eine Ausgangsstufe (23) mit einer Eingangsstufe (25) eines sechsten Stromspiegels (24) gekoppelt ist, der mit einer Ausgangsstufe (26) an der Ausgangsklemme (53) angeschlossen ist.

8. Schaltung nach Anspruch 7 in Verbindung mit Anspruch 4, dadurch gekennzeichnet, daß die Ausgangsstufen (13, 26) des zweiten und des sechsten Stromspiegels (12, 24) miteinander verbunden sind.

9. Schaltung nach Anspruch 8, dadurch gekennzeichnet, daß die erste und die zweite Stromquelle (4, 9) jeweils eine Ausgangsstufe (29, 30) einer in einer Integrated-Injection-Logik-Schaltungstechnik ausgebildeten Strombank ist, mit Transistoren, deren Basen mit einem gemeinsamen Injektor (40, 32) verbunden sind.

## Claims

1. A Schmitt-trigger circuit for converting an input signal (Ue) at an input terminal (52) into an output signal (Ua) at an output terminal (53), which circuit comprises a differential amplifier (1) comprising a first transistor (2) and a second transistor (3) each having a base, an emitter and a collector, the emitters of the first and the second transistor (2, 3) being coupled to a first current source (4), the base of the first transistor (2) being coupled to the input terminal and the collector of the second transistor (3) being coupled to an input of a first current mirror (5), and the base of the second transistor (3) being coupled to an output of the first current mirror (5), characterized in that the base of the second transistor (3) is coupled to a second current source (9) and to the output of the first current mirror (5) via a semiconductor junction and to a first diode array which comprises at least two series-arranged diode elements (10, 11) arranged in the forward direction for the current flowing to the second current source and arranged in parallel with the first current mirror (5) and the semiconductor junction.

2. A circuit as claimed in Claim 1, characterized in that the semiconductor junction is a base-emitter junction of a feedback transistor (8) which has its base coupled to the output of the first current mirror (5) and its emitter to the base of the second transistor.

3. A circuit as claimed in Claim 1 or 2, characterized in that a second diode array (43, 44) is arranged between a first coupling point of the base of the second transistor (3) and the second current source (9), and a second coupling point of the semiconductor junction and the first diode array (10, 11).

4. A circuit as claimed in Claim 1, 2 or 3, characterized in that the first diode array is arranged in the input current-path of an input stage of a second current mirror (12) having an output stage (13) connected to the output terminal (53).

5. A circuit as claimed in Claim 2, 3 or 4, characterized in that the collector of the first transistor (2) is connected to an input of a third current mirror (14) which has an output coupled to an input of a fourth current mirror (15) having an output connected to the base of the feedback transistor (8).

6. A circuit as claimed in Claim 5, characterized in that the input terminal (52) is coupled to the base of the first transistor (2) via an input diode array (33).

7. A circuit as claimed in Claim 1, 2, 3, 5 or 6, characterized in that the input of the first current mirror (5) is preceded by an input stage (22) of a fifth current mirror (21), which has an output stage (23) coupled to an input stage (25) of a sixth current mirror (24) having an output stage (26) connected to the output terminal (53).

8. A circuit as claimed in Claim 7, where appendant to Claim 4 characterized in that the output stages (13, 26) of the second and the sixth current mirror are interconnected.

9. A circuit as claimed in Claim 8, characterized in that the first and the second current source (4, 9) each form an output stage (29, 30) of a current-source array which is constructed in integrated injection logic technology and which comprises transistors whose bases are connected to a common injector (40, 32).

## Revendications

1. Circuit déclencheur de Schmitt pour transformer un signal d'entrée (Ue) à une borne d'entrée (52) en un signal de sortie (Ua) à une borne de sortie (53), où le circuit contient un amplificateur différentiel (1) avec un premier et un deuxième transistor (2, 3), comportant chaque fois, une base, un émetteur et un collecteur, les émetteurs du premier et du deuxième transistor (2, 3) étant couplés à une première source de courant (4), la base du premier transistor (2), à la borne d'entrée et le collecteur du deuxième transistor (3), à l'entrée d'un premier miroir de courant (5) et la base du deuxième transistor (3), à la sortie du premier miroir de courant (5), caractérisé en ce que la base du deuxième transistor (3) est couplée à une deuxième source de courant (9) et, via une section de semi-conducteur, à la sortie du premier miroir de courant (5), ainsi qu'à une première section de diodes constituée d'au moins deux diodes élémentaires (10, 11) connectées en série pour le passage du courant s'écoulant vers la deuxième source de courant, qui est montée en parallèle avec le premier miroir de courant (5) et avec la section de semi-conducteur.

2. Circuit selon la revendication 1, caractérisé en ce que la section de semi-conducteur est une section base-émetteur d'un transistor de rétroaction (8), dont la base est connectée à la sortie du premier miroir de courant (5) et dont l'émetteur est couplé à la base du deuxième transistor.

3. Circuit selon la revendication 1 ou 2, caractérisé en ce qu'entre un premier point de couplage de la base du deuxième transistor (3) avec la deuxième source de courant (9) et un deuxième point de couplage de la section de semi-conducteur avec la première section de diodes (10, 11), est montée une deuxième section de diodes (43, 44).

4. Circuit selon la revendication 1, 2 ou 3, caractérisé en ce que la première section de diodes est reçue, pour le courant, dans l'étage d'entrée d'un deuxième miroir de courant (12), qui est connecté par son étage de sortie (13) à la borne de sortie (53).

5. Circuit selon la revendication 2, 3 ou 4, caractérisé en ce que le collecteur du premier transistor (2) est connecté à une entrée d'un troisième miroir de courant (14), dont une sortie est couplée à une entrée d'un quatrième miroir de courant (15), dont une sortie est couplée à la base du transistor de rétroaction (8).

6. Circuit selon la revendication 5, caractérisé en ce que la borne d'entrée (52) est couplée à la base du premier transistor (2) via une section de diodes d'entrée (33).

7. Circuit selon la revendication 1, 2, 3, 5 ou 6, caractérisée en ce que, en amont de l'entrée du premier miroir de courant (5) est monté un étage d'entrée (22) d'un cinquième miroir de courant (21), dont un étage de sortie (23) est couplé à un étage d'entrée (25) d'un sixième miroir de courant (24), qui est connecté par son étage de sortie (26) à la borne de sortie (53).

8. Circuit selon la revendication 7 en liaison avec la revendication 4, caractérisé en ce que les étages de sortie (13, 26) du deuxième et du sixième miroir de courant (12, 24) sont connectés l'un à l'autre.

9. Circuit selon la revendication 8, caractérisé en ce que la première et la deuxième source de courant (4, 9) sont, chacune, l'étage de sortie (29, 30), d'une banque de courant formée selon une technique de circuits logiques d'injection intégrés, comportant des transistors dont les bases sont connectées à un injecteur commun (40, 32).

Fig.1

Fig.2

Fig.3

Fig.4